# EUROPEAN PATENT APPLICATION

(11) **EP 1 152 646 A1**
(43) Date of publication of application: **07.11.2001**
(21) Application number: 00977871.3
(22) Date of filing: 22.11.2000
(51) Int. Cl.: H05H 1/46, H01L 21/3065

(54) **METHOD AND APPARATUS FOR PLASMA TREATMENT**

(30) Priority: 25.11.1999 JP 37597499
(71) Applicant: TOKYO ELECTRON LIMITED, Minato-ku, Tokyo 107-8481 (JP); Ohmi, Tadahiro, Sendai-shi, Miyagi-ken 980-0813 (JP)
(72) Inventor: OHMI, Tadahiro, Sendai-Shi, Miyagi 980-0813 (JP); HIRAYAMA, Masaki, Sendai-shi, Miyagi 984-0806 (JP); KAIHARA, Ryuu, Sendai-shi, Miyagi 982-0834 (JP)
(74) Representative: Liesegang, Eva
(86) International application number: JP0008247
(87) International publication number: WO0139559

(57) **Abstract**

A substrate (101) subjected to a plasma process is placed on a first electrode (102). A magnetic field is applied to a surface of the substrate to which the plasma process is applied by magnetic field applying means (103). An auxiliary electrode (104) is provided on an outer periphery of the first electrode (102) to excite plasma on a back surface (105) thereof. Electrons in the plasma are caused to drift from a front surface (106) to a back surface (105) of the auxiliary electrode (104) and from the back surface (105) to the front surface (106) of the auxiliary electrode (104).

## Description

### TECHNICAL FIELD

The present invention generally relates to a plasma processing apparatus and, more particularly, to a plasma processing apparatus which applies a magnetic field to a surface of a substrate to which a plasma process is applied and a plasma processing method performed b such a plasma processing apparatus.

### BACKGROUND ART

Etching of a silicone oxidization film or a polycrystalline silicon film is one of the most important process in production of a semiconductor, and plasma etching has been used as such etching. In order to form a fine pattern of 1.0 µm or less by plasma etching, plasma having an ion current density of 1 mA/cm² or more and an electron density of 1 10 cm⁻³ or more is required under a process pressure of 0.5 Pa or less. However, a conventionally used RIE apparatus of a parallel plate type was not able to generate plasma of such conditions.

In order to achieve the above-mentioned plasma performance, a plasma generating apparatus using a magnetic field has been developed. As an apparatus provided with such a plasma generating apparatus, Japanese Laid-Open Patent Application No. 6-37056 discloses a magnetron plasma etching apparatus using a dipole ring-magnet.

The magnetron plasma etching apparatus using a dipole-ring magnet is able to generate low pressure and high-density plasma. However, it is difficult to control the plasma generated on a substrate with high accuracy. That is, it becomes difficult to attain equalization of the plasma density on a substrate and equalization of a self-bias voltage by introducing a horizontal magnetic field on the substrate.

As solution which attains equalization of plasma density and a self-bias voltage, a method of giving a slope to a magnetic field (Japanese Laid-Open Patent Application No. 62-21062) or a method of rotating a magnetic field introduced into a process space (Japanese Laid-Open Patent Application No. 61-208223) is suggested. However, the solution suggested in Japanese Laid-Open Patent Application No. 62-21062 has a problem in that the optimum value of a slope magnetic field changes when a process pressure etc. is changed. Additionally, although the solution suggested in Japanese Laid-Open Patent Application No. 61-208223 apparently achieves equalization of plasma with respect to a substrate being processed, the mechanism for rotating the magnetic field is required, and there is a problem in that a miniaturization of the whole plasma apparatus is difficult.

In order to solve the above-mentioned problems, the method of equalizing plasma by generating a uniform horizontal magnetic field by applying a high frequency electric power to an auxiliary electrode. In this solution method, an electron drift is generated in a direction opposite to an electron drift generated on a surface of the substrate placed on a lower electrode so as to promote circulation of electrons in the plasma, which prevents deviation of electrons. According to this solution, even if it is the case where process pressure etc. is changed, it is possible to attain equalization of plasma by changing the electric power of the radio frequency applied to the auxiliary electrode. Additionally, since it is not necessary to rotate a magnetic field, it is possible to attain a miniaturization of the plasma apparatus.

However, in association with increase of sizes of semiconductor chips such as DRAM or MPU, the diameter of the silicone substrate used as a base thereof has become large gradually. For example, in order to suppress a pressure distribution to less than several percent in the plasma apparatus which processes a substrate having a diameter of 300 mm or more, it is necessary to set a distance between the substrate and an upper electrode as 30 mm or more. In such a distance, diffusion of electrons which go from the surface of the substrate to the surface of the auxiliary electrode and from the auxiliary electrode to the surface of the substrate is suppressed. As a result, a movement of electrons is prevented and it is difficult to equalize the plasma.

Additionally, in the conventional sputter apparatus using a magnetron plasma source, an amount of reduction of a target material is uneven, and there is a problem in that an efficiency of use of the target is less than 50%. In order to solve such a problem, a method of using a generally uniform parallel magnetic field is considered. In such a case, it is necessary to rotate eh magnetic field or the substrate during a process. Therefore, the stress in a thin film formed on the substrate spreads to the entire substrate, and there is a problem in that the substrate is deformed due to relaxation of the stress during a machining process as a post process. Further, since the surface of the substrate is exposed to uneven plasma during film deposition process, a control of a film quality on the entire surface of the substrate is very difficult. For example, in a sputter apparatus which forms copper wiring, there is a problem in that the resistance of the formed copper wiring is as large as several times of a target value (theoretical value).

### DISCLOSURE OF INVENTION

It is a general object of the present invention to provide an improved and useful plasma processing apparatus in which the above-mentioned problems are eliminated.

A more specific object of the present invention is to provide a plasma processing apparatus which can equalize the generation plasma density with respect to a surface of a substrate and a self-bias potential while maintaining a pressure distribution on the substrate uniform.

Another object of the present invention is to provide a plasma processing apparatus which can perform uniform etching without a charge-up damage to a substrate.

A further object of the present invention is to provide a plasma processing apparatus which can perform sputter which is uniform with respect to a substrate and does not generate a stress.

In order to achieve the above-mentioned objects, there is provided a plasma processing apparatus a plasma processing apparatus comprising a first electrode on which a substrate subjected to a plasma process is placed and magnetic field applying means for applying a magnetic field to a surface of the substrate to which the plasma process is applied, characterized in that: an auxiliary electrode is provided on an outer periphery of the first electrode to excite plasma by the auxiliary electrode so as to cause electrons in the plasma to drift from a front surface to a back surface of the auxiliary electrode and from the back surface to the front surface of the auxiliary electrode.

The front surface of the auxiliary electrode may be covered by an insulating material. Additionally, it is preferable that a level of a surface of the substrate placed on the first electrode and a level of the front surface of the auxiliary electrode are equal to each other or within ±2 mm. The magnetic field applying means may comprise a dipole ring-magnet. It is preferable that a frequency f1 of a radio frequency applied to the first electrode and a frequency f2 of a radio frequency applied to the auxiliary electrode are equal to each other and phases thereof are different from each other. Further, it is preferable that a frequency f2 of a radio frequency applied to the auxiliary electrode is higher than a frequency f1 of a radio frequency applied to the first electrode (f2>f1).

Other objects, features and advantages of the present invention will become more apparent from the following detailed description when read in conjunction with the accompanying drawings.

### BRIEF DESCRIPTION OF DRAWINGS

FIG. 1 is a structural diagram of a plasma processing apparatus according to a first embodiment of the present invention.
FIG. 2 is a perspective view of a substrate, a first electrode and an auxiliary electrode of the plasma processing apparatus shown in FIG. 1.
FIG. 3 is a plane view of the auxiliary electrode.
FIG. 4 is a plane view showing a variation of the auxiliary electrode.
FIG. 5 is a graph showing a self-bias potential measured in the plasma processing apparatus according to the first embodiment of the present invention.
FIG. 6 is a graph showing an ion current density measured in the plasma processing apparatus according to the first embodiment of the present invention.
FIG. 7 is a structural diagram of a plasma sputter film deposition apparatus according to a second embodiment of the present invention.
FIG. 8 is a cross-sectional view of an auxiliary electrode in a third embodiment of the present invention.
FIG. 9 is a graph showing a radio frequency electric power applied to an auxiliary electrode, which can make a self-bias potential the most uniform in cases where a surface of the auxiliary electrode is covered or not covered by an insulating material.
FIG. 10 is a graph showing an amount of consumption of an inner wall of a process chamber.
FIG. 11 is a graph showing a result of measurement of an amount of consumption of the auxiliary electrode by applying a radio frequency electric power, of which frequency is higher than a radio frequency electric power applied to the first electrode, to the auxiliary electrode.
FIG. 12 is a graph showing a change in the radio frequency electric power applied to the auxiliary electrode needed to uniform the self-bias potential by a difference in a height between an upper surface of the first electrode and an upper surface of the auxiliary electrode.
FIG. 13 is an illustration showing an action of an electron drift when the surface of the first electrode is higher than the surface of the auxiliary electrode.
FIG. 14 is an illustration showing an action of an electron drift when the surface of the first electrode is lower than the surface of the auxiliary electrode.

### BEST MODE FOR CARRYING OUT THE INVENTION

A description will be given below, with reference to the drawings, of embodiments of the present invention.

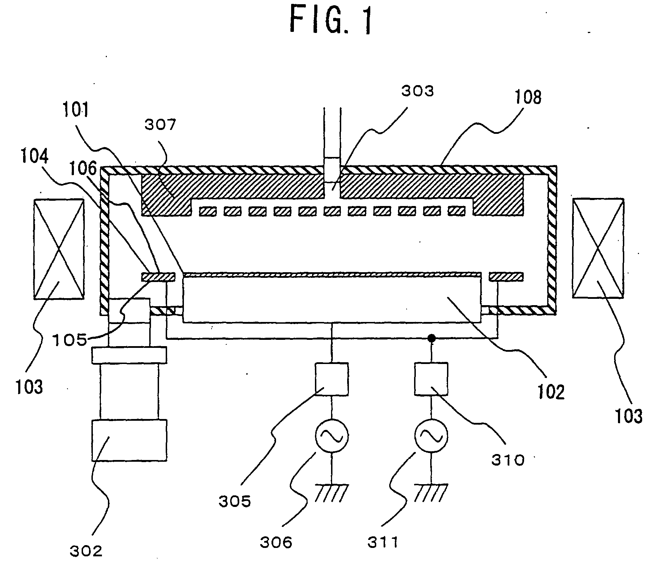

FIG. 1 is a structural diagram of a plasma processing apparatus according to a first embodiment of the present invention. In the plasma processing apparatus shown in FIG. 1, a substrate 101 to which a plasma process is applied is placed on an electrode 102. A plasma process applied to the substrate 101 by exciting plasma on the surface of the substrate 101. The dipole ring-magnet 103 is provided in the circumference of a process chamber 108 in which the substrate 101 is accommodated as a means to apply a magnetic field. As a means to apply a magnetic field, although a permanent magnet or an electromagnet may be used, it is preferable to use a dipole ring-magnet when installation capacity, electric power consumption, magnetic field leakage, etc. are taken into consideration.

An auxiliary electrode 104 is installed on an outer periphery of the first electrode 102. The auxiliary electrode may surround the entire periphery or a part of the periphery of the first electrode 102. The auxiliary electrode 104 is provided so as to excite plasma in the vicinity of the back surface 105 and the front surface 106 thereof.

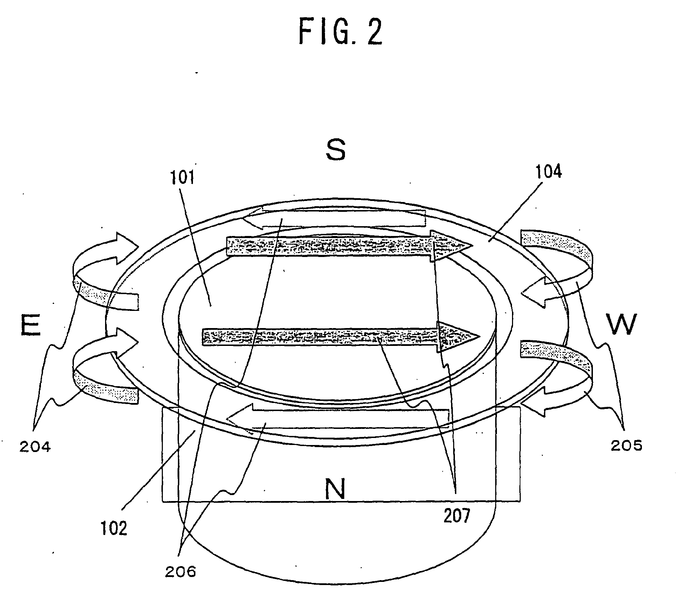

FIG. 2 is a perspective view of the substrate 101, the first electrode 102 and the'auxiliary electrode 104 of the plasma processing apparatus shown in FIG. 1. An arrow 204 shows the drift of electrons to the front surface 106 from the back surface 105 of the auxiliary electrode 104, and an arrow 205 shows the drift of electrons to the back surface 105 from the front surface 106 of the auxiliary electrode 104. An arrow 206 indicated by the dotted line shows the drift of electrons in the vicinity of the back surface 105 of the auxiliary electrode 104, and an arrow 207 shows the drift of electrons in the vicinity of the surface of the substrate 101 and the front surface 106 of the auxiliary electrode 104. The drift of electrons indicated by arrows 204, 205, 206 and 207 is generated by the interaction of a magnetic field or a magnetic field and substrate and a sheath electrode generated between the substrate and the auxiliary electrode.

In the conventional magnetron plasma apparatus, the drift of electrons shown by arrows 204, 205 and 206 hardly occurs, but only the drift of electrons shown by the arrow 207 occurs. For this reason, electrons in the plasma shift toward the W-pole, which results in generation of uneven plasma.

In the plasma processing apparatus according to the present embodiment, electrons generated by the surface of the substrate 101 and the auxiliary electrode 104 flow according to the electron drift on the surface of the substrate and the front surface of the auxiliary electrode 104 (indicated by the arrow 207, the electron drift from the front surface 106 to the back surface 105 of the auxiliary electrode 104 (indicated by the arrow 205), the electron drift on the back surface 106 of the auxiliary electrode 104 (indicated by the arrow 206), the electron drift from the back surface 105 to the front surface 106 of the auxiliary electrode 104 (indicated by the arrow 204) and diffusion movement of electrons. According to the flow of electrons, electrons in the plasma are prevented from moving in a certain direction of the applied magnetic field, thereby achieving uniformization of the entire plasma.

As mentioned above, the plasma processing apparatus shown in FIG. 1 comprises: the first electrode 102 on which the substrate 101 to which a plasma process is applied is placed; the magnetic field applying means 103 for applying a magnetic field to the surface to which the plasma process is applied; and the auxiliary electrode 104 provided on an outer periphery of the first electrode 102, wherein electrons in the plasma is caused to drift from the front surface 106 to the back surface 105 of the auxiliary electrode 104 and from the back surface 105 to the front surface 106 of the auxiliary electrode 104 by exciting plasma on the front surface 106 and the back surface 105 of the auxiliary electrode 104.

A description will now be given of a structure of the plasma processing apparatus shown in FIG. 1 in the case of using the plasma processing apparatus as a plasma etching apparatus. The process chamber 108 shown in FIG. 1 is made of aluminum, and the turbo-molecular pump 302 is provided on the bottom thereof as an exhaust means. The turbo-molecular pump 302 exhausts and depressurizes the gas from inside a chamber 301. Additionally, a gas introduction port is provided in the process chamber 108 as a gas introduction means so as to introduce gas, such as C₄F₈, carbon monoxide, oxygen or xenon, into process chamber 108 through the gas introduction port 303. The inside of the process chamber 108 is maintained at a desired pressure by the introduction of the gas and the exhaust of the gas by the turbo numerator pump 302. The combination of the above-mentioned gases is not limited to eh above mentioned combination, and as other examples there are C4F8, carbon monoxide, oxygen, argon, etc. Additionally, since C₄F₈, carbon monoxide, oxygen and xenon are preferable since they suppresses an excessive dissociation of gas and improve the etching characteristic.

The first electrode 102 is connected to a radio frequency power supply 306 having a frequency of 13.56 MHz via a matching circuit 305. Although the frequency of the radio frequency power supply can also be set to 27.12 MHz or 40 MHz, a radio frequency of about 13.56 MHz is preferable, when etching of an oxidization film is performed, at which a self-bias potential of the plasma becomes large. In etching of an insulated film, it is preferable to set a high self-bias at an initial stage so as to etch at a high speed, and to set a low self-bias at an etching end stage. Accordingly, a damage of the background of the insulated film can be reduced.

A grounded second electrode 307 is provided above the first electrode 102. Although parallel plate type electrode is used as the second electrode 307 in the present embodiment, a plasma source electrode such as a multi-target type, a microwave excitation type, an electron cyclotron resonance type or an induction coupling type may be used. In order to improve the etching characteristic, the parallel plate type is preferable. The substrate 101 of silicon which has a silicon oxidization film is placed on the surface of the first electrode 102.

The auxiliary electrode 104 is connected to a radio frequency power supply 311 having a frequency of 100 MHz via a matching circuit 310. The magnetic field applying means 103 in the present embodiment is a dipole ring-magnet of 12 mT (120 Gausses).

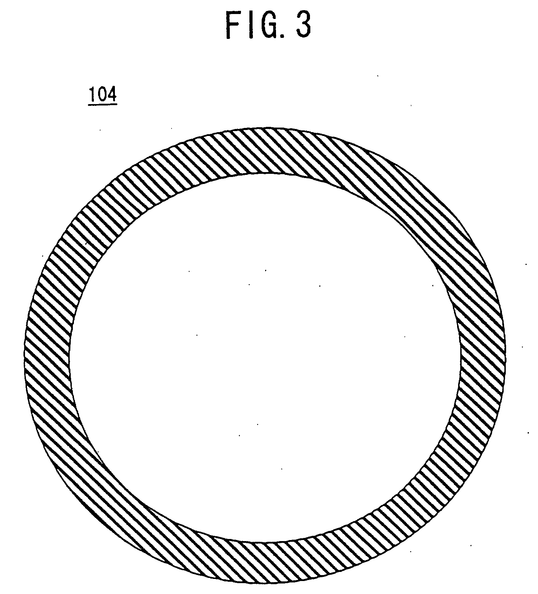

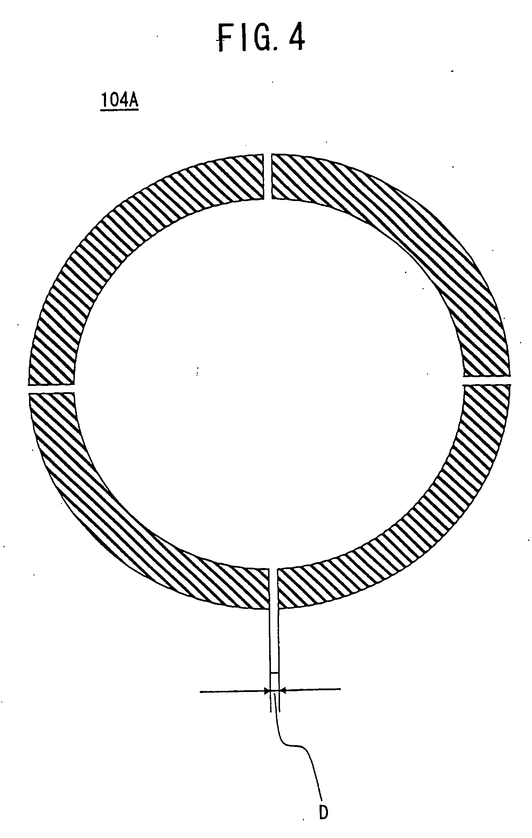

FIG. 3 is a plan view of the auxiliary electrode 104. Although the ring-shaped auxiliary electrode 104 is used in the present embodiment, the auxiliary electrode 104 may be divided into four parts like an auxiliary electrode 104A as shown in FIG. 4. In this case, a distance D between the divided parts is preferably within 2 mm which is within an electron cycloid radius.

As shown in FIG. 2, by arranging the auxiliary electrode 104 on the outer periphery of the first electrode 102, the drift (indicated by the arrow 207) of electrons from the E-pole to the W-pole in the applied magnetic field occurs on the surface of the substrate 101 and the front surface 106 of the auxiliary electrode 104, and the drift (indicated by the arrow 206) of electrons from the W-pole to the E-pole of the applied magnetic field occurs on the back surface 105 of the auxiliary electrode 104. Moreover, on the W-pole side of the auxiliary electrode 104, the drift (indicated by the arrow 205) of electrons from the back surface 105 to the front surface 106 occurs, and the drift (indicated by the arrow 204) of electrons from the back surface 105 to the front surface occurs on the E-pole side of the auxiliary electrode 104. By such electron drift, deviation of electrons can be prevented by the electron being caused to flow, and uniformization of plasma is achieved.

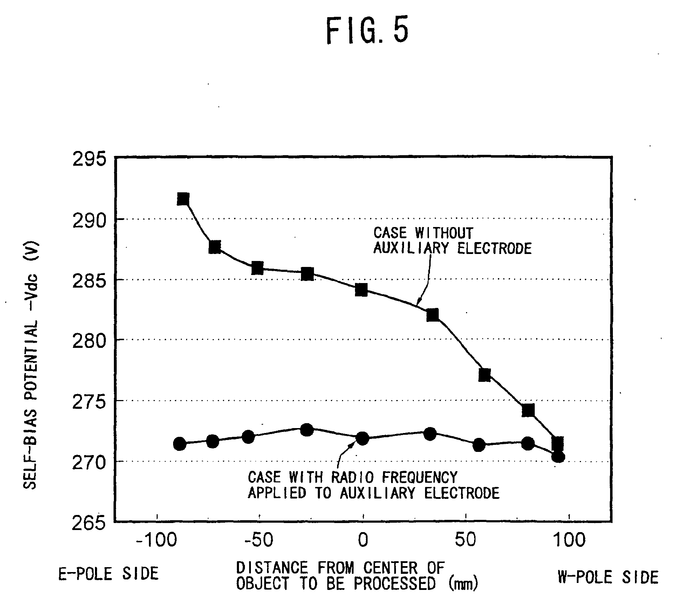

FIG. 5 is a graph showing the self-bias potential measured in the plasma processing apparatus according to the present embodiment. Measurements were taken for the case where the auxiliary electrode 104 is provided and the case where the auxiliary electrode 104 is not provided. In the case where the auxiliary electrode 104 is not provided, the structure is the same as that of a regular magnetron plasma apparatus. As appreciated from FIG. 5, when the auxiliary electrode 104 was not provided, a self-bias potential difference of 20 V occurred between the E-pole side and the W-pole side on the substrate. However, self-bias potential difference was able to be set to 2 V by providing the auxiliary electrode 104 on the outer periphery of the first electrode 102 as in the present embodiment.

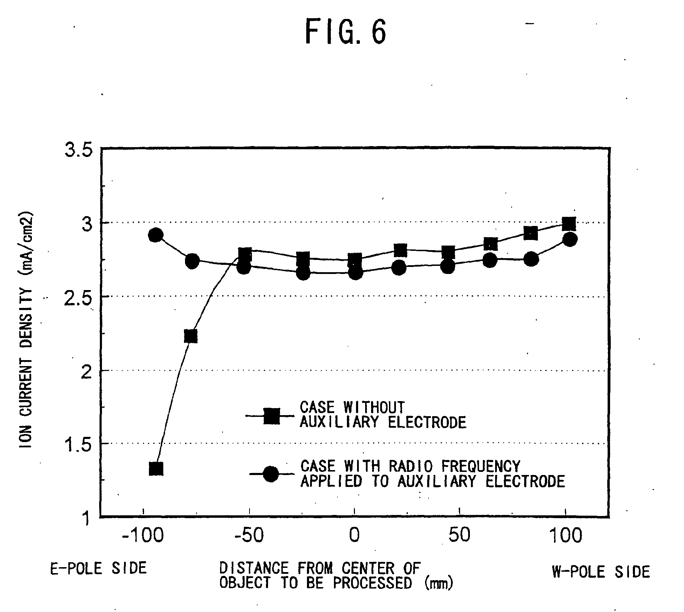

FIG. 6 is a graph showing an ion current density measured in the plasma processing apparatus according to the present embodiment. When the auxiliary electrode 104 was not provided, the ion current density dropped extremely on the E-pole side. However, like the present embodiment, by providing the auxiliary electrode 104 on the outer periphery of the first electrode, the drop of the ion current on the side of the E-pole was able to be eliminated, and was able to achieve a uniform ion current density on the substrate.

Using the plasma etching apparatus according to the present invention, a silicon substrate was etched by introducing a mixed gas of C₄F₈, carbon monoxide, oxygen, and xenon into the process chamber 108 and setting the chamber pressure to 5 Pa. The silicone substrate had a silicone oxidization film with a thickness of 1.6 micrometers formed on the surface thereof, and the diameter was 200 mm. When a radio frequency electric power of 1500 W was supplied to the first electrode 102 and a high frequency electric power of 200 W was supplied to the auxiliary electrode 104, the uniformity of the etching rate was ±2%.

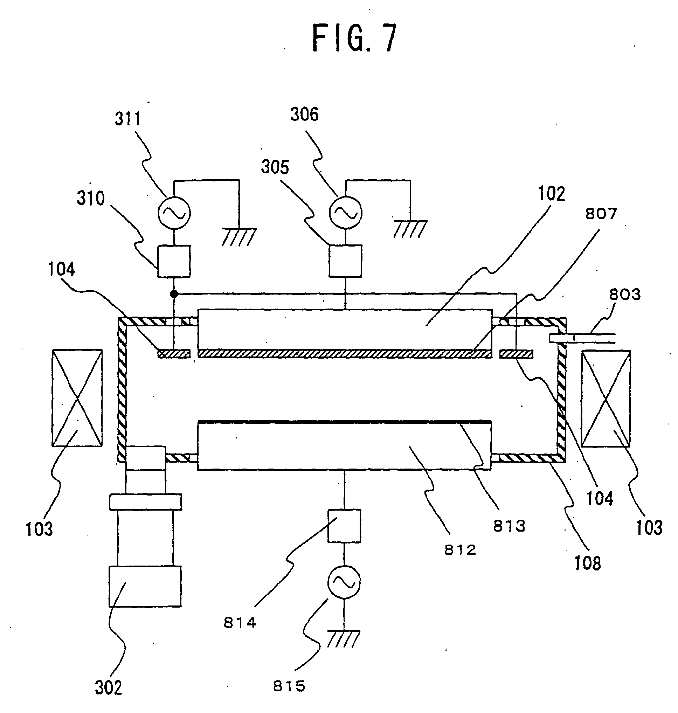

A description will now be given, with reference to FIG. 7, of a second embodiment of the present invention. FIG. 7 is a structural diagram of a plasma sputtering apparatus according to the second embodiment of the present invention. In FIG. 7, parts that are the same as the parts shown in FIG. 1 are given the same reference numerals, and descriptions thereof will be omitted.

The process chamber 108 shown in FIG. 7 is made of aluminum, and a protective film is provided by forming an aluminum fluoride by applying a fluoride treatment to an inner surface thereof. The process chamber 108 is not limited to such a structure, and it is preferable to from an inner wall which discharge an extremely small amount of gas such as water other than a process gas. Similar to the plasma processing apparatus shown in FIG. 1, the inside of the process chamber 108 is depressurized by using the turbo-molecular pump 302. Additionally, argon gas is introduced into the process chamber 108 from the gas supply passage 803 as a gas introduction means. The gas to be used is not limited to argon gas, and a mixture gas of xenon or krypton and oxygen may be used. Argon is preferable for a copper sputtering film deposition.

The first electrode 102 is connected to the radio frequency power supply 306 having a frequency of 13.56 MHz via the matching circuit 305. The frequency of the radio frequency power supply 306 is not limited to this frequency and 27.12 MHz or 40 MHz may be used. As for sputtering, a frequency near 13.56 MHz is preferable at which the self-bias potential generated on the target surface becomes large. A substrate 807 as a copper target is attached to a surface of the first electrode 102. Although the copper target is used in the present embodiment, the target is not limited to copper and a material to be deposited can be attached as the target. The auxiliary electrode 104 is connected to the radio frequency power supply 311 having a frequency of 100 MHz via the matching circuit 310. The dipole ring-magnet 103 of 12 mTs (120 Gausses) is used as a magnetic field applying means.

A second electrode 812 is arranged in the position, which counters with first electrode 102. A silicon substrate 813 having a surface on which a silicone oxidization film is formed is placed on the second electrode 812. Additionally, the second electrode 812 is connected to a radio frequency power supply 815 having a frequency of 40 MHz via a matching circuit 814. The frequency of the radio frequency power supply 815 is not limited to this frequency, and 13.56 MHz or 27.12 MHz may be used. A higher frequency is preferable in order to increase the quantity of ions which irradiate the silicon substrate and to reduce the self-bias potential to be generated.

Copper sputtering was performed on the silicone substrate 813 by using the sputtering apparatus according to the present embodiment. Argon gas was introduced into the process chamber 108 and the pressure was set to 0.1 Pa. A radio frequency electric power of 1500 W was supplied to the first electrode 102, and a radio frequency electric power of 200 W was supplied to the auxiliary electrode 104. Consequently, a copper thin film was formed on the substrate 813, which film has no stress at all and has a film thickness uniformity of ±2% and a resistivity of 2.76 µΩ.

A description will now be given of a plasma etching apparatus according to a third embodiment of the present invention. The plasma processing apparatus according to the third embodiment of the present invention is provided with an auxiliary electrode having a surface covered by an insulating material instead of the auxiliary electrode 104.

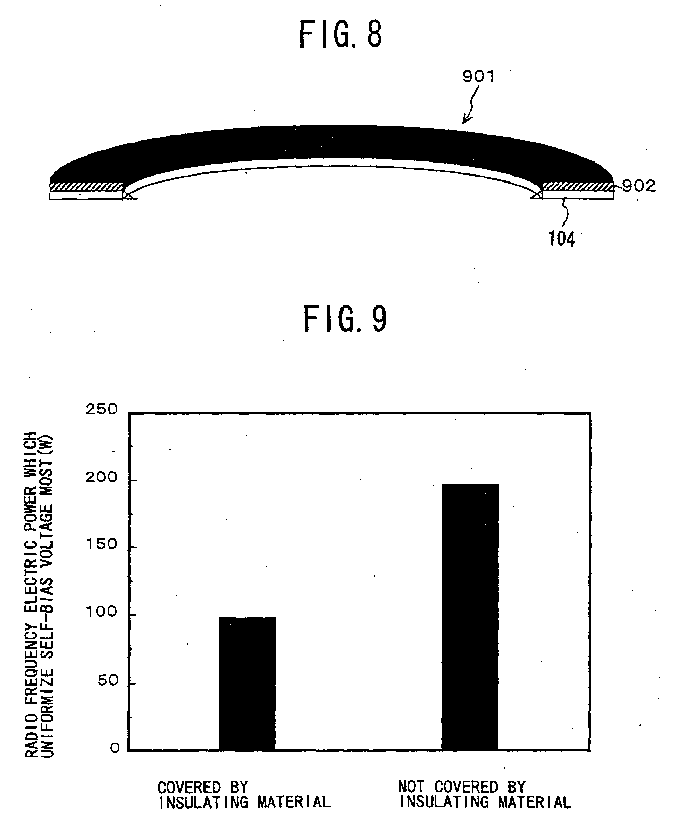

FIG. 8 is a cross-sectional view of an auxiliary electrode 901 in the present embodiment. The auxiliary electrode 901 has an insulator 902 formed on the surface 106 of the auxiliary electrode 104. In the present embodiment, although the insulator 902 is formed of aluminum nitride AlN, it can be formed of quartz, alumina, Teflon, polyimide, etc. AlN is preferable because of a high thermal conductivity and a high plasma resistance. It should be noted that other parts of the auxiliary electrode 901 are the same as the parts shown in FIG. 1, and descriptions thereof will be omitted.

FIG. 9 is a graph showing a radio frequency electric power applied to the auxiliary electrode, which can make a self-bias potential the most uniform in cases where a surface of the auxiliary electrode is covered or not covered by an insulating material. When the surface of the auxiliary electrode was not covered by an insulator, the radio frequency electric power which can make a self-bias potential uniform was 200 W. On the other hand, it was 100 W when covered by an insulator.

Using the plasma etching apparatus according to the present embodiment, a silicon substrate was etched by introducing a mixed gas of C₄F₈, carbon monoxide, oxygen, and xenon into the process chamber 108 and setting the chamber pressure to 5 Pa. The silicone substrate had a silicone oxidization film with a thickness of 1.6 µm formed on the surface thereof, and the diameter was 200 mm. A radio frequency electric power of 1500 W was supplied to the first electrode 102 and a high frequency electric power of 200 W was supplied to the auxiliary electrode 104. As a result, the uniformity of the etching rate was ±2%.

A further detailed description will be given of a result of measurement with respect to the plasma etching apparatus according to the above-mentioned first embodiment.

First, a description will be given of a case in which a radio frequency electric power having a frequency of 13.56 MHz, which is the same as the radio frequency electric power supplied to the first electrode 102, is supplied to the auxiliary electrode 104 while varying the phase from 0 degree to 180 degrees.

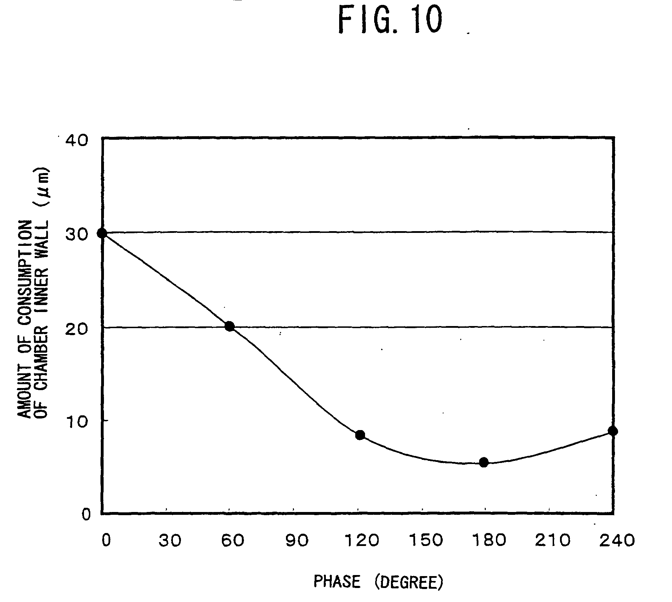

FIG. 10 is a graph showing an amount of consumption of the inner wall of the process chamber in the above-mentioned condition. After exciting plasma for 24 hours, change of the thickness in the inner wall of the process chamber was measured. In a case where a radio frequency of 13.56 MHz was applied to the first electrode 102 in phase of 0 degree, the thickness of the chamber decreased by 30 µm. On the other hand, when the radio frequency was applied with antiphase of 180 degrees, the thickness of the chamber decreased by 7 µm, and there was least reduction of the thickness of the chamber.

Additionally, using the plasma etching apparatus according to the present embodiment, a silicon substrate was etched 300 times by introducing a mixed gas of C₄F₈, carbon monoxide, oxygen, and xenon into the process chamber and setting the pressure to 5 Pa, the silicone substrate having a silicone oxidization film with a thickness of 1.6 µm formed on the surface thereof and the diameter thereof being 200 mm. As a result, the consumption of the inner wall of the chamber was about 7 µm. In a conventional etching apparatus, the inner wall of the chamber is consumed about 50 µm in the same condition. Therefore, the consumption of the inner wall of the chamber was able to be reduced to 1/7 by using the plasma etching apparatus according to the present embodiment.

It was found from the above-mentioned results that by applying a radio frequency electric power having a frequency the same as that applied to the first electrode 102 but having a different phase to the auxiliary electrode, the inner wall of the chamber was prevented from being sputtered and was prevented from being sputtered at most at the antiphase since the plasma potential was reduced.

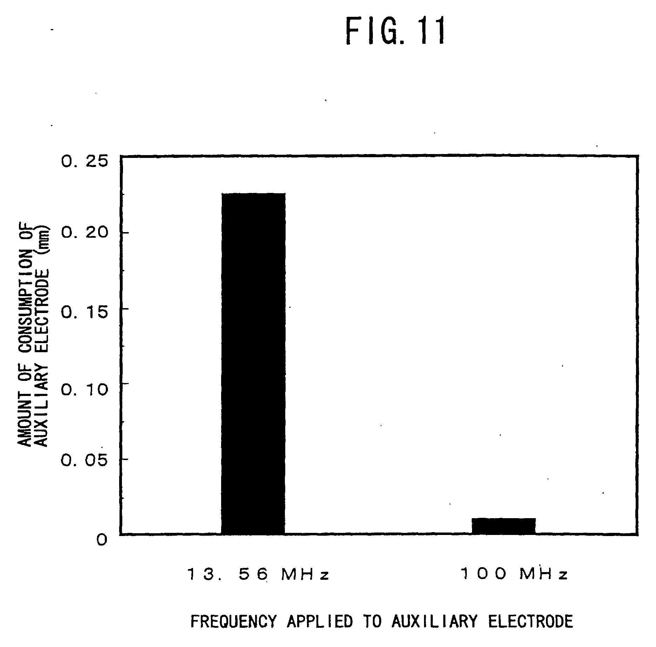

Next, the amount of consumption of the auxiliary electrode 104 was measured by applying to the auxiliary electrode a radio frequency electric power having a frequency of 100 MHz which is higher than the frequency 13.56 MHz of the radio frequency electric power applied to the first electrode. FIG. 11 is a graph showing the results of measurement.

As shown in FIG. 11, by increasing the frequency of the radio frequency power supply 311 connected to the auxiliary electrode 104, the self-bias voltage generated in the auxiliary electrode 104 can be suppressed and an amount of consumption of the auxiliary electrode 104 sue to sputtering can be reduced. Although the radio frequency electric powers of 13.56 MHz and 100 MHz were used in the measurement, the present invention is not limited to this combination, and a radio frequency electric power of about 27 MHz may be applied to the first electrode 102 and a radio frequency electric power of 60 MHz may be applied to the auxiliary electrode 104. Alternatively, radio frequency electric powers of 40 MHz and 80 MHz may be applied to the first electrode 102 and the auxiliary electrode 104, respectively. Although there are various frequencies of the radio frequency electric power applied to the first electrode 102 and the auxiliary electrode 104 as mentioned above, a higher frequency is preferable for the radio frequency applied to the auxiliary electrode 104.

As mentioned above, by increasing the frequency of the radio frequency power supply 311 connected to the auxiliary electrode 104, the self-bias voltage generated in the auxiliary electrode 104 can be suppressed, and the consumption of the auxiliary electrode 104 due to sputtering can be reduced.

Additionally, using the plasma etching apparatus shown in FIG. 1, a silicon substrate was etched 300 times by introducing a mixed gas of C₄F₈, carbon monoxide, oxygen, and xenon into the process chamber and setting the pressure to 5 Pa. The silicone substrate had a silicone oxidization film with a thickness of 1.6 µm formed on the surface thereof and the diameter thereof was 200 mm. As a result measurement of the amount of consumption of eh auxiliary electrode 104, the amount of consumption was about 5 mm. Since the amount of consumption in a conventional etching apparatus is 65 mm, the amount of consumption was reduced to 1/13 of that of the conventional apparatus.

Next, the radio frequency electric power as investigated, which is applied to the auxiliary electrode and is able to make the self-bias potential most uniform by the position relationship (height relationship) between the surface of the first electrode 102 and the front surface 106 of the auxiliary electrode 104.

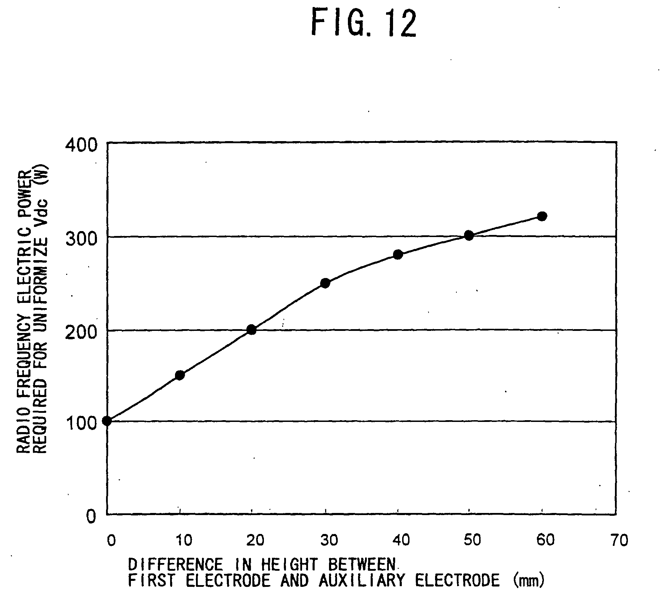

FIG. 12 is graph showing changes in the radio frequency electric power, which is applied to the auxiliary electrode and required to uniformize a self-bias potential according to the difference in the height between the upper surface of first electrode 102 and the upper surface 106 of the auxiliary electrode 104. When the height of the upper surface of the first electrode 102 and the height of the upper surface 106 of the auxiliary electrode 104 were equal to each other, the radio frequency electric power, which is applied to the auxiliary electrode and required in order to uniformize the self-bias potential, was 100 W. The radio frequency electric power applied to the auxiliary electrode and required to uniformize the self-bias potential increased as the difference in the height was increased, and the radio frequency electric power was 300 W when the height difference was 50 mm. Therefore, it was found that the radio frequency electric power applied to the auxiliary electrode required to uniformize the self-bias potential can be made the lowest when the height of the upper surface of the first electrode 102 and the upper surface 106 of the auxiliary electrode 104 were equal to each other.

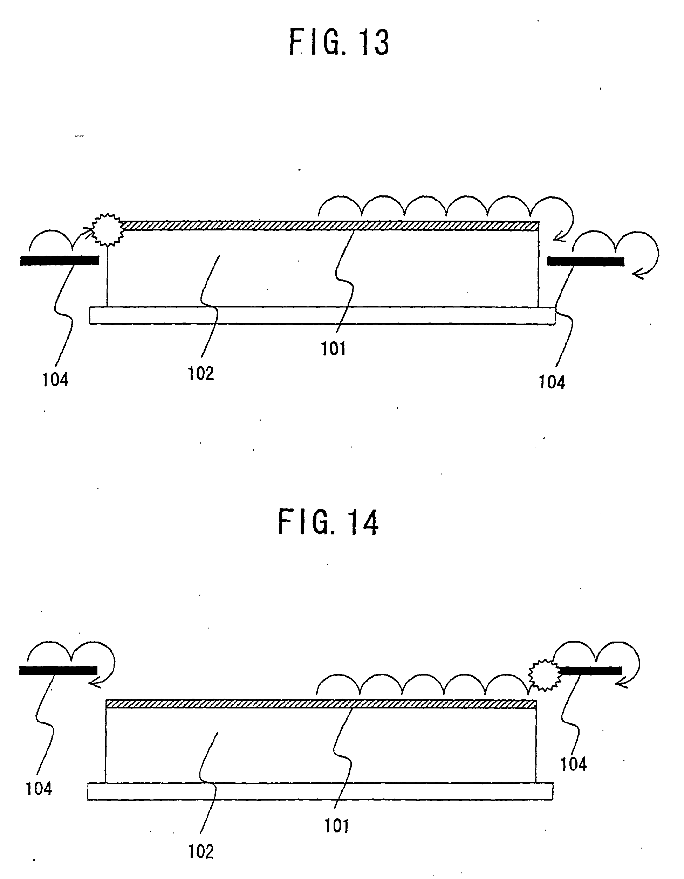

FIG. 13 is an illustration showing the action of an electronic drift when the surface of the first electrode 102 is higher than the front surface 106 of the auxiliary electrode 104. FIG. 14 is an illustration showing the action of an electronic drift when the surface of the first electrode 102 is lower than the front surface 106 of the auxiliary electrode 104.

As shown in FIG. 13, in order to prevent the drift of electrons generated on the front surface 106 of the auxiliary electrode 104 from disappearing due to collision with the first electrode 102, the difference between the height of the surface of the first electrode 102 and the height of the position of the surface 106 of the auxiliary electrode 104 needs to be smaller than the cycloid radius of the electron drift. Moreover, in order to prevent the electron drift generated on the surface of the substrate 101 from disappearing due to collision with the auxiliary electrode 104, the difference between the height of the surface of the first electrode 102 and the height of the position of the front surface 106 of the auxiliary electrode 104 needs to be smaller than the cycloid radius of the electron drift.

Therefore, the self-bias potential can be equalized with a small radio frequency electric power by setting the height of the surface 106 of the auxiliary electrode 104 equal to the surface of the substrate 101 or setting the difference between the height of the front surface 106 of the auxiliary electrode 104 and the height of the surface of substrate 101 equal to or less than 2 mm.

Additionally, using the plasma etching apparatus according to the present embodiment, a silicon substrate was etched by introducing a mixed gas of C₄F₈, carbon monoxide, oxygen, and xenon into the process chamber and setting the chamber pressure to 5 Pa. The silicone substrate had a silicone oxidization film with a thickness of 1.6 µm formed on the surface thereof, and the diameter was 200 mm. A radio frequency electric power of 1500 W was supplied to the first electrode 102 and a high frequency electric power of 100 W was supplied to the auxiliary electrode 104. As a result, the uniformity of the etching rate was ±2%.

As explained above, according to the plasma processing apparatus of the present invention, uniformization of the density of the generated plasma with respect to the surface of the substrate and uniformization of the self-bias potential can be attempted without rotating the magnetic field applying means independently of the shape of the upper electrode and the distance thereof while maintaining the pressure distribution on the substrate uniform, and, thereby, the etching process without a charge up damage or the sputtering process which is uniform with respect to the substrate and does not generate a stress can be performed.

Additionally, a plasma processing apparatus having a high radio frequency electric power efficiency can be realizable by covering the surface of the auxiliary electrode by an insulating material.

Further, a plasma processing apparatus having a high radio frequency electric power efficiency can be realizable by equalizing the level of the surface of the substrate placed on the first electrode and the level of the front surface of the auxiliary electrode or setting the difference of the heights to less than ±2 mm.

Additionally, a plasma processing apparatus with a small electric power, a small installation volume and a small magnetic field leakage can be realized by using a dipole magnet-ring as the magnetic field applying means.

Additionally, a plasma processing apparatus in which a chamber wall is prevented from being sputtered can be realized by setting a frequency f1 of a radio frequency applied to the first electrode and a frequency f2 of a radio frequency applied to the auxiliary electrode equal to each other and differentiating phases from each other.

Furthermore, a plasma processing apparatus in which a consumption of the auxiliary electrode is_ suppressed is realized by setting a frequency f2 of a radio frequency applied to the auxiliary electrode higher than a frequency f1 of a radio frequency applied to the first electrode (f2>f1).

## Claims

1. A plasma processing apparatus comprising a first electrode (102) on which a substrate (101; 807) subjected to a plasma process is placed and magnetic field applying means (103) for applying a magnetic field to a surface of the substrate (101; 807) to which the plasma process is applied,
**characterized in that**:
an auxiliary electrode (104) is provided on an outer periphery of said first electrode (102) to excite plasma by the auxiliary electrode (104) so as to cause electrons in the plasma to drift from a front surface (106) to a back surface (105) of said auxiliary electrode (104) and from the back surface (105) to the front surface (106) of said auxiliary electrode (104).

2. The plasma processing apparatus as claimed in claim 1, **characterized in that** the front surface (106) of said auxiliary electrode (104) is covered by an insulating material (902).

3. The plasma processing apparatus as claimed in claim 1 or 2, **characterized in that** a level of a surface of the substrate (101) placed on said first electrode (102) and a level of the front surface of said auxiliary electrode (104) are equal to each other or within ±2 mm.

4. The plasma processing apparatus as claimed in claim 1 or 2, **characterized in that** said magnetic field applying means (103) comprises a dipole ring-magnet.

5. The plasma processing apparatus as claimed in claim 1 or 2, **characterized in that** a frequency f1 of a radio frequency applied to said first electrode (102) and a frequency f2 of a radio frequency applied to said auxiliary electrode (104) are equal to each other and phases thereof are different from each other.

6. The plasma processing apparatus as claimed in claim 1 or 2, **characterized in that** a frequency f2 of a radio frequency applied to said auxiliary electrode (104) is higher than a frequency f1 of a radio frequency applied to said first electrode (102) (f2>f1).

7. A plasma processing method performed in a plasma processing apparatus comprising a first electrode (102) on which a substrate (101) subjected to a plasma process is placed and magnetic field applying means (103) for applying a magnetic field to a surface of the substrate (101) to which the plasma process is applied,
**characterized by**:
exciting plasma on at least a back surface (105) of an auxiliary electrode (104) provided on an outer periphery of said first electrode; and
cause electrons in the plasma to drift from a front surface (106) to the back surface (105) of said auxiliary electrode (104) and from the back surface (105) to the front surface (106) of said auxiliary electrode (104).
